(19) Europäisches Patentamt / European Patent Office / Office européen des brevets

(11) **EP 4 250 567 A1**

(12) **EUROPEAN PATENT APPLICATION**

(43) Date of publication:
**27.09.2023  Bulletin 2023/39**

(21) Application number: **22305351.3**

(22) Date of filing: **23.03.2022**

(51) International Patent Classification (IPC):
**H03K 17/14** (2006.01)  **H03K 17/687** (2006.01)
**H03K 17/16** (2006.01)  **H01L 29/16** (2006.01)

(52) Cooperative Patent Classification (CPC):
**H03K 17/145; H03K 17/165; H03K 17/687**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Mitsubishi Electric R&D Centre Europe B.V.
  1119 NS  Schiphol Rijk Amsterdam (NL)**
  Designated Contracting States:
  **FR**
• **Mitsubishi Electric Corporation
  Tokyo 100-8310 (JP)**
  Designated Contracting States:
  **AL AT BE BG CH CY CZ DE DK EE ES FI GB GR HR HU IE IS IT LI LT LU LV MC MK MT NL NO PL PT RO RS SE SI SK SM TR**

(72) Inventor: **BRANDELERO, Julio
35708 RENNES CEDEX 7 (FR)**

(74) Representative: **Plasseraud IP
66, rue de la Chaussée d'Antin
75440 Paris Cedex 09 (FR)**

(54)    **ACTIONS AGAINST GATE DETERIORATION OF POWER SEMICONDUCTORS**

(57)    A treatment method of a power semi-conductor module (1) comprising at least one semiconductor element (11) including a Metal-Oxide-Semiconductor element and/or a Metal-Insulator-Semiconductor element, said method comprising:

a. acquiring a first value $V_{soh,0}$ corresponding to an initial state of health of a gate oxide of the module (1);

b. acquiring a second value $V_{soh,X}$ corresponding to a current state of health of a gate oxide of the module (1);

c. deducing

an ON-state gate voltage Vcc or an OFF-state gate voltage gate voltage $V_{EE}$, and

a delay time of the turn-on $t_{ON}$ or a delay time of the turn-off $t_{OFF}$

in function of said acquired first value $V_{soh,0}$ and said second value $V_{soh,X}$;

d. generating at least one control signal (CTRL) configured to apply the deduced gate voltage Vcc or $V_{EE}$ to the module (1) during the deduced delay time $t_{ON}$ or $t_{OFF}$.

FIG. 5

EP 4 250 567 A1

## Description

### Technical Field

This disclosure pertains to the field of monitoring, limiting, slowing down and/or reducing the intrinsic degradation of power semiconductors during operational service.

### Background Art

The gate oxide quality of the power semiconductor modules during its operational life is known as a key parameter for the reliability concern of such devices.

For SiC MOSFET in particular, it seems that the gate oxide (GOX) film is a key point of the reliability: SiC MOSFET devices have a failure probability up to four orders of magnitude than Si MOSFET.

Decreasing the positive gate-source voltage could increase the reliability of the devices. A negative bias is commonly used as a countermeasure to avoid the self-turn-on of a device during the switching-on of a series electrically connected device. However, due to some idle time of the power semiconductor, a negative bias can be applied for several hours which will lead to a decrease on the threshold voltage. This variation is critical in the initial seconds on the converter start switching again. In addition, gate over-voltages occur during the switching times of the gate, which also contributes to a shift on the threshold voltage.

There are known solutions to improve the substrate defect density, and theoretically the reliability such: limitation on the gate oxide field in blocking mode and in on-state, avoidance of voltage spicks and $SiC/SiO_2$ interface passivation. However, the known solutions to maintain a gate oxide quality have various negative effects in some operational conditions of the power semiconductor modules.

### Summary

This disclosure improves the situation.

It is proposed a treatment method of a power semi-conductor module comprising at least one semiconductor element including a Metal-Oxide-Semiconductor element and/or a Metal-Insulator-Semiconductor element, said method comprising:

    a. acquiring a first value $V_{soh,0}$ corresponding to an initial state of health of a gate oxide of the module;
    b. acquiring a second value $V_{soh,X}$ corresponding to a current state of health of a gate oxide of the module;
    c. deducing

        an ON-state gate voltage Vcc or an OFF-state gate voltage gate voltage $V_{EE}$, and
        a delay time of the turn-on $t_{ON}$ or a delay time of the turn-off $t_{OFF}$
        in function of said acquired first value $V_{soh,0}$ and said second value $V_{soh,X}$;

    d. generating at least one control signal configured to apply the deduced gate voltage Vcc or $V_{EE}$ to the module during the deduced delay time $t_{ON}$ or $t_{OFF}$.

In another aspect, it is proposed a power semi-conductor module comprising a single Metal-Oxide-Semiconductor element or a set of Metal-Oxide-Semiconductor elements or a single Metal-Insulator-Semiconductor element or a set of Metal-Insulated-Semiconductor elements, said module being arranged to implement such a method.

In another aspect, it is proposed a computer software comprising instructions to implement the method as defined here when the software is executed by a processor. In another aspect, it is proposed a computer-readable non-transient recording medium on which a software is registered to implement the method as defined here when the software is executed by a processor.

The following features, can be optionally implemented, separately or in combination one with the others:

The method further comprises the following preliminary operation:

- switching said at least one semiconductor element

        * from an ON-state to an OFF-state, according to a control logic signal with a zero or negative gate voltage $V_{EE}$ and with a delay time for the turning-off $t_{OFF}$;
        or
        * from an OFF-state to an ON-state, according to a control logic signal with a positive gate voltage Vcc and with a delay time for the turning-on $t_{ON}$.

The sign of the applied gate voltage Vcc or $V_{EE}$ depends on the ON/OFF state of said at least one semiconductor element.

Criteria to deduce the delay time of the turn-on $t_{on}$ or the delay time of the turn-off $t_{OFF}$ in function of said acquired first value $V_{soh,0}$ and said acquired second value $V_{soh,X}$ includes the following:

- if the acquired second value $V_{soh,X}$ is superior to the acquired first value $V_{soh,0}$, the delay time of the turn-off $t_{OFF}$ is increased with respect to a previous value of the delay time of the turn-off $t_{OFF}$;
- if the acquired second value $V_{soh,X}$ is inferior to the acquired first value $V_{soh,0}$, the delay time of the turn-off $t_{OFF}$ is decreased with respect to a previous value of the delay time of the turn-off $t_{OFF}$.

Criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

- if the acquired second value $V_{soh,X}$ is superior to the acquired first value $V_{soh,0}$, the ON-state gate voltage Vcc is increased with respect to a previous value of the ON-state gate voltage Vcc, and the increasing is proportional or equal to the difference between the acquired first value $V_{soh,0}$ and the acquired second value $V_{soh,X}$.

Criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

- if the acquired second value $V_{soh,X}$ is superior to the acquired first value $V_{soh,0}$, the OFF-state gate voltage $V_{EE}$ is decreased with respect to a previous value of the OFF-state gate voltage $V_{EE}$;
- if the acquired second value $V_{soh,X}$ is inferior to the acquired first value $V_{soh,0}$, the OFF-state gate voltage $V_{EE}$ is increased with respect to a previous value of the OFF-state gate voltage $V_{EE}$;
- if the acquired second value $V_{soh,X}$ is equal to the acquired first value $V_{soh,0}$, the OFF-state gate voltage $V_{EE}$ is maintained equal to a previous value of the OFF-state gate voltage $V_{EE}$.

Criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

- if the acquired second value $V_{soh,X}$ is superior to the acquired first value $V_{soh,0}$, the OFF-state gate voltage $V_{EE}$ is decreased with respect to a previous value of the OFF-state gate voltage $V_{EE}$;
- if the acquired second value $V_{soh,X}$ is inferior to the acquired first value $V_{soh,0}$, the ON-state gate voltage Vcc is increased with respect to a previous value of the ON-state gate voltage Vcc;
- if the acquired second value $V_{soh,X}$ is equal to the acquired first value $V_{soh,0}$, the ON-state gate voltage Vcc and the OFF-state gate voltage $V_{EE}$ are each reinitialized to their respective value by default.

The method further comprises the following operation:

- when a reverse conduction of the semiconductor element is detected, generating at least one control signal configured to apply the deduced gate voltage Vcc or $V_{EE}$ to the module.

At least two second values $V_{soh,X}$ and $V_{soh,X+1}$ are acquired during the lifetime of the module, and a criteria to deduce the ON-state gate voltage Vcc or an OFF-state gate voltage gate voltage $V_{EE}$ in function of said acquired first value $V_{soh,0}$ and said acquired second values $V_{soh,X}$ and $V_{soh,X+1}$ includes the following:

- if the temporal derivative of the said acquired second values $dV_{soh,X}/dt$ is positive, the ON-state gate voltage Vcc is decreased with respect to a previous value of the ON-state gate voltage Vcc and/or the OFF-state gate voltage $V_{EE}$ is decreased with respect to a previous value of the OFF-state gate voltage $V_{EE}$;
- if the temporal derivative of the said acquired second values $dV_{soh,X}/dt$ is negative, the ON-state gate voltage Vcc is increased with respect to a previous value of the ON-state gate voltage Vcc and/or the OFF-state gate voltage $V_{EE}$ is increased with respect to a previous value of the OFF-state gate voltage $V_{EE}$.

Criteria to deduce the delay time of the turn-on $t_{ON}$ or the delay time of the turn-off $t_{OFF}$ is further dependent from the ON-state gate voltage Vcc and/or the OFF-state gate voltage gate voltage $V_{EE}$.

## Brief Description of Drawings

Other features, details and advantages will be shown in the following detailed description and on the figures, on which:

**Fig. 1**

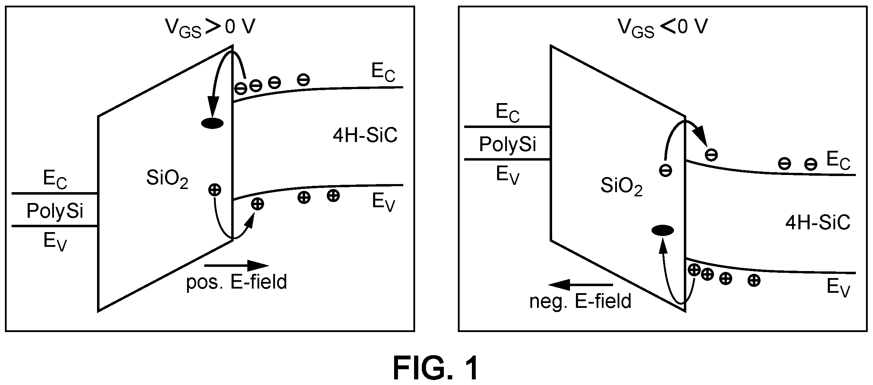

[Fig. 1] is a schematical representation of a physical phenomenon.

**Fig. 2**

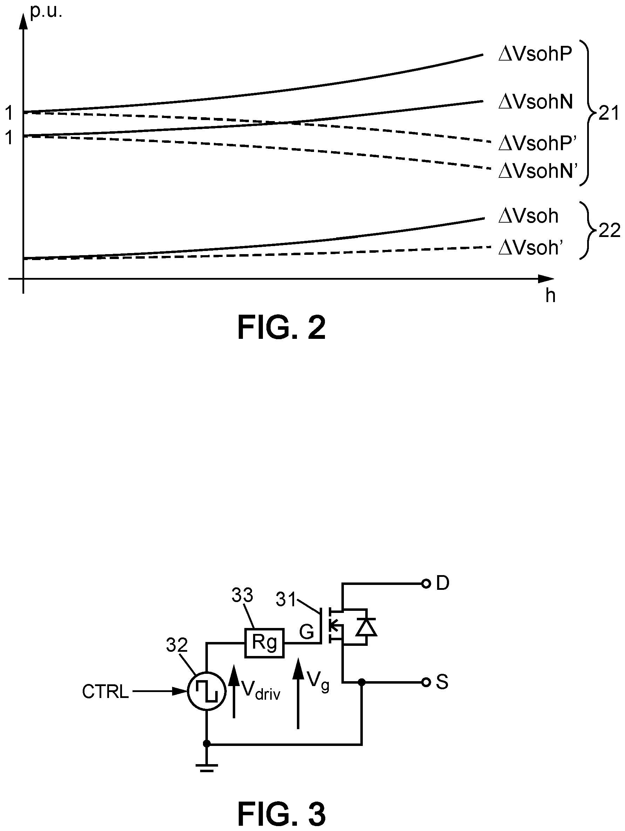

[Fig. 2] is schematic representation of the evolution of some index during the lifetime of a power semiconductor element.

**Fig. 3**
[Fig. 3] is an example of a circuit with a semiconductor element.

**Fig. 4**

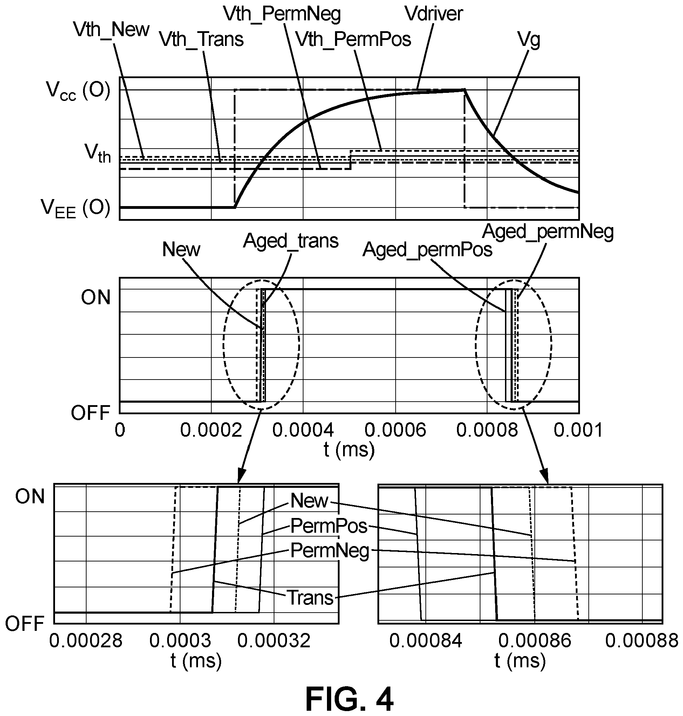

[Fig. 4] is a superposition of gate driver switching waveforms for various situations.

**Fig. 5**

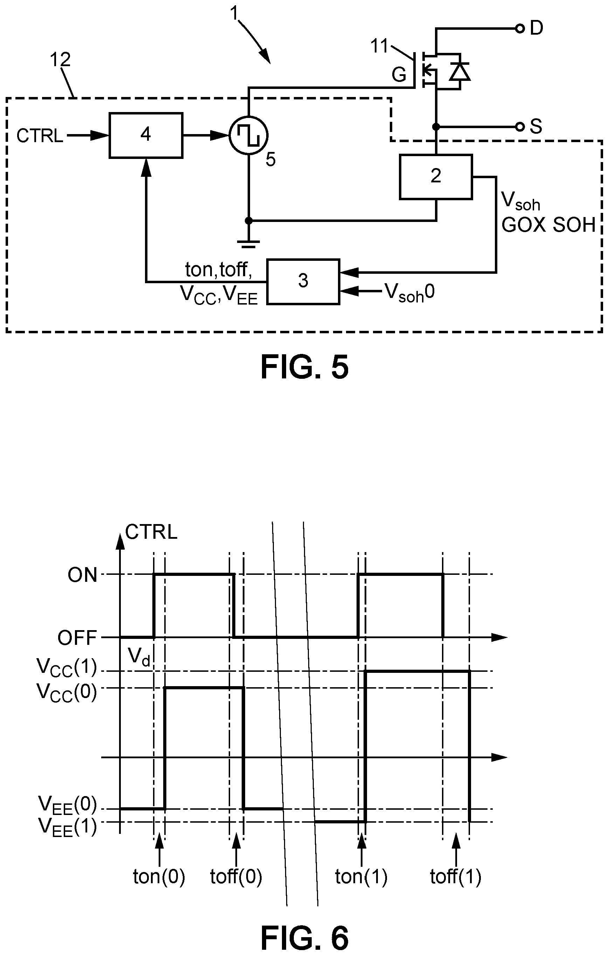

[Fig. 5] is a circuitry according to an embodiment.

**Fig. 6**
[Fig. 6] is a graphic view of some values during an embodiment.

## Main problems to solve

Bias temperature instability (BTI) is a reliability issue concerning the insulated gate power modules, such Metal-Oxide-Semiconductor-Field-Effect-Transistors (MOSFET), Insulated-Gate-Bipolar-Transistors (IGBT) and High-Electron-Mobility-Transistors (HEMT). In the SiC power semiconductor elements, this phenomenon is much more problematic during the device lifetime than in Si power semiconductor elements (approximately ten times higher), due to the reduced band offsets between the gate oxide and the power semiconductor occurrence and the carbon atoms degrading the atomically smooth $Si/SiO_2$ interface. The charge trapping also concerns the reliability in GaN HEMTs devices, due to the gate stack structure complexity.

The charge trapping can be a permanent or a transitory phenom which the main consequences of this reliability issue are:

i/ "On-state resistance RDS(on) increase" - leading to an over-loss dissipation on the devices/modules and an over-temperature during the power semiconductor elements operation which can be catastrophic for the integrity of the materials;

ii/ "Body diode threshold voltage" - leading to an over-loss dissipation on the element and an over-temperature during the power semiconductor operation;

iii/ "Off-state blocking leakage IDSS(off)" - that will generate extra losses on the element and can also lead to a catastrophic failure;

iv/ "Shoot-Through Currents" - given the change in the ON and OFF time delay. The initial dead time from power semiconductor cannot be enough to switch the series devices safely and create catastrophic short circuit failure.

In each previous concerns, the extra losses generated by the deterioration will increase the temperature of the power semiconductor which accelerates the degradation.

Identifying the gate oxide degradation under on-line operation of the power semiconductor is a key parameter to assess the reliability of such devices: from a test and safety assessment point of view (including standards) and dispatch/maintenance of the power converter.

## Theory

The flatband voltage $V_{fb}$ is a voltage that when applied to a semiconductor element generates a flat energy band in the semiconductor and is determined by the following equation [Math. 1]:

[Math. 1]

$$V_{fb} = \Phi_{MS} - \frac{Q_{ox}}{C_{ox}} - \frac{1}{\varepsilon_{ox}} \int_0^{t_{ox}} \rho_{ox}(x) \cdot x \cdot dx$$

$\Phi_{MS}$ is the work function difference between the gate metal material and the semiconductor material. $C_{ox}$ is the thin oxide capacitance. $Q_{ox}$ is the total effective charge in the oxide. The last term of [Math. 1] is due to the charge density in the oxide.

Ones can note that the flatband voltage is affected by the presence of charges on the oxide-semiconductor interface. The charges presented in this interface are sensitive to the electric field formed on the channel. As the positive gate voltages generate a positive electrical field conducting to a negative charge accumulation on the oxide, the flatband voltage increases by the equation [Math. 1]. In an opposite way, as the negative gate voltages generate a negative electrical field conducting to a positive charge accumulation on the oxide, the flatband voltage decreases by the equation [Math. 1]. This phenomenon is called Bias Temperature Instability, or BTI. For a positive electrical field, it is called Positive Temperature Bias instability (PBTI). And for a negative electrical field, this is called Negative Temperature Bias Instability (NBTI).

[Fig. 1] is based on a figure published in the following paper: X. Zhong and e. al, "Bias Temperature Instability of Silicon Carbide Power MOSFET Under AC Gate Stresses" IEEE Transactions on Power Electronics, vol. 37, no. 2, pp. 1998-2008, Feb. 2022, doi: 10.1109/TPEL.2021.3105272. [Fig. 1] illustrates the above-described phenomena, the left part corresponding to a situation wherein the gate-source voltage $V_{GS}$ is superior to 0 V, while the right part corresponds to a situation wherein the gate-source voltage $V_{GS}$ is inferior to 0 V.

Despite the efforts during design to avoid the incorporation of charges on the oxide, during the lifetime of the power semiconductor element, positive or negative electrical fields will trap charges on the gate oxide. This phenomenon is hardly avoided in the case of SiC or GaN semiconductors materials where more interface states and fixed oxide charge appear after a high electric field application. The trapped charge is also significantly increased with a high switching frequency and/or by a hot device temperature.

One of the main consequences of the gate oxide deterioration is the evolution on the threshold voltage $V_{th}$ that is described as per following equations [Math. 2] and [Math. 3].

[Math. 2]

$$V_{th} = V_{fb} + 2\,\Phi_f + \frac{\sqrt{4 \cdot \varepsilon_s \cdot q \cdot N_a \cdot \Phi_f}}{C_{ox}}$$

[Math. 3]

$$\Phi_f = \frac{k\,T}{q} ln \frac{N_a}{ni}$$

$N_a$ is the acceptor density in the substrate. $\varepsilon_s$ is the semiconductor dielectric constant. k is the Boltzmanns constant. T is the temperature. ni is the intrinsic carrier concentration. $C_{ox}$ is the oxide capacitor value.

As the gate and the substrate doping and the oxide thickness are not affected by the voltage bias stress, the noticeable change on the threshold voltage $V_{th}$ is related to the changes on the oxide charges and then can be monitored only by the measurement of the flatband voltage $V_{fb}$ as per following equation [Math. 4].

[Math. 4]

$$\Delta V_{th} = V_{th(fresh)} - V_{th(stress)} = V_{fb(fresh)} - V_{fb(stress)}$$

The changes on the gate oxide can be transitory or permanent. The transitory changes are related to the high frequency such the switching frequency on the range of the tens of kHz to hundreds of kHz. The permanent changes are related to period measured in several hours/days. The aggravation factors are the long OFF-state period, e.g. the idle time of the module, or the long ON-state period, such the solid-state power controller application (solid-state relay). Both modes have consequences on:

- the conduction losses, as the transfer characteristic, from the gate voltage $V_g$ to the main voltage $V_{CE}$, $V_{DS}$, and current Ic, $I_D$, is modified. This will impact the conduction losses of the power semiconductor element;
- the switching times, as the threshold voltage is varying.

As a result of the gate oxide degradation, it can be seen in the [Fig. 2], [Fig. 3] and [Fig. 4] the switching times are modified in function of the level of the threshold voltage $V_{th}$. [Fig. 2] represents a classical circuit including a semiconductor element 31 (a transistor) wherein the gate voltage $V_g$ is controlled with a voltage source 32 ($V_{driv}$) and a gate resistance 33 ($R_g$) on the gate branch G. Graphics of [Fig. 4] show comparative switching waveforms in function of the situation of a same semiconductor element 31:

- the index "New" corresponds to a situation wherein the semiconductor element 31 is new (nominal situation);
- the index "PermPos" corresponds to the effect of a permanent and positive gate oxide deterioration;
- the index "PermNeg" corresponds to the effect of a permanent and negative gate oxide deterioration;
- the index "Trans" corresponds to the effect of a transitory gate oxide deterioration.

[Fig. 2] represents the evolution of some indexes during the lifetime (in days) when the gate is driven with a standard pattern, the indexes 21 corresponding to permanent changes and the indexes 22 corresponding to transitory changes:

- positive gate bias ΔVsohP;
- negative gate bias ΔVsohN;
- transitory state of health change ΔVsoh = ΔVsohP - ΔvsohN.

The solid lines correspond to index "PermPos" of [Fig. 4] while dotted lines and indexes with a "prime" (') correspond to "PermNeg" of [Fig. 4].

The defaults generated at the turn-on state are:

- caused by a decrease of the threshold voltage $V_{th}$, the turn-on taking place before the desired time. A short-through current can appear on a half-bridge configuration where a series power-semiconductor element works in a complementary state;
- caused by an increase of the threshold voltage $V_{th}$, the turn-on taking place after the desired time. A body-diode conduction will occurs increasing the total system losses.

The defaults generated at the turn-off state are:

- caused by an increase of the threshold voltage $V_{th}$, the turn-off taking place before the desired time. A body-diode conduction will occurs increasing the total system losses;
- caused by a decrease of the threshold voltage $V_{th}$, the turn-off taking place after the desired time. A short-through current can appear on a half-bridge configuration where a series power-semiconductor element works in a complementary state.

In terms of system safety, the anticipation of the turn-on and the delay of turn-off can cause severe damage on the devices given a large short-through current.

An aim, here, is to remove, or at least reduce, the impact of the gate oxide deterioration by acting on the control gate driver voltage that will result in a gate voltage to control the power semiconductor element. Furthermore, a dedicate gate voltages are controlled to also reduce and/or remove the gate oxide deterioration.

**Description of Embodiments**

It is referred to [Fig. 5] and [Fig. 6]. In the following, power semi-conductor modules 1 are assembly comprising at least one Metal-Oxide-Semiconductor (MOS) element or a Metal-insulator-Semiconductor (MIS). Even if the module 1 comprises a plurality of MOS elements, there are considered as single one in the following: there is a common gate G, a common source S and a common drain D. For this reason, it is referred to a single gate, a single source and a single drain in the following without distinction of embodiments with a single one or a plurality of MOS elements. The word "power" is used in its general meaning of the technical field of energy conversion (power electronics).

An aim of the following method is to adapt the gate control voltages and switching timings to reduce or neutralize the charge trapping effects while maintaining as much as possible output characteristics $V_{DS}$ and $I_D$. The proposed method can be used in operational conditions, typically not only on a test bench but when the module is integrated and interconnected in its operational and industrial environment.

The module 1 comprises at least one semiconductor element 11 (here a transistor) and a control circuitry 12 including:

- means for detecting the state of health of the gate oxide, here for example a detection module 2;
- means for comparing the current state of health of the gate oxide with the initial state of health, here for example a calculation module 3,
- means to decide on the delay time of the turn-on $t_{on}$, the delay time of the turn-off $t_{off}$, the ON state voltage Vcc, and the OFF state voltage $V_{EE}$, here for example the calculation module 3;
- means for convert the control signal CTRL into the required gate signal, here for example an actuation module 4;
- means to drive the gate, here for example a controllable gate driver voltage source 5.

Only as examples, the calculation module 3 can comprise a digital or an analogue controller. The actuation module 4 can comprise a programmable delay generator, as for example the commercial reference "AD9500", or the delay can be generated by an FPGA. The controllable gate driver voltage source 5 can be a variable voltage source, as for example a linear gain control amplifier. The gate driver voltage source can be a push-pull, a totem-pole voltage source or a class B amplifier.

The method comprises the following operations:

a. acquiring a first value $V_{soh,0}$ corresponding to an initial state of health of a gate oxide of the module 1;
b. acquiring a second value $V_{soh,X}$ corresponding to a current state of health of a gate oxide of the module 1;
c. deducing a gate voltage Vcc or $V_{EE}$ and a delay time $t_{ON}$ or $T_{OFF}$ in function of said acquired first value $V_{soh,0}$ and said second value $V_{soh,X}$;
d. generating at least one control signal CTRL configured to apply the gate voltage Vcc or $V_{EE}$ to the module 1 during the delay time $t_{ON}$ or $t_{OFF}$.

The acquisition of the states of health (the initial one $V_{soh,0}$ and/or the current one $V_{soh,X}$) can be made by the detection module 2. For example, fast Measure-Stress-Measure (MSM) techniques can be executed to determine the current state of health of the gate oxide. The measures are made just after the stress. Examples are proposed:

1. measure of the threshold voltage $V_{th}$;
a kelvin-source voltage, generated by the temporal derivative of the current di/dt during the semiconductor element 11 turn-on/off switching times, is used to trigger the gate-source voltage $V_{GS}$ measure that is taken as $V_{soh}$;
2. measure of the turn-on/off delays: a kelvin-source voltage, generated by the temporal derivative of the current di/dt during the semiconductor element 11 turn-on/off switching times, is used to trigger a timer that is converted to a $V_{soh}$.

Such MSM techniques are advantageous because only gate connections are necessary. But, in various embodiments, other techniques to acquire the state of health can be used.

The classical voltage values during ON state, Vcc, is around 15V (classically between 10V and 20V) and the OFF state, $V_{EE}$, is around -5V (classically between -20V and 0V).

In the embodiment shown on [Fig. 5], the calculation module 3 is configured to receive the current state of health $V_{soh,X}$ from the detection module 2. The calculation module 3 is further configured to compare the received current state of health $V_{soh,X}$ to the initial state of health $V_{soh,0}$. The gate driver voltage source 5 is configured to control the gate of the semiconductor element 11, between ON and OFF states following the external control signal CTRL modified by the actuation module 4. The instants of the transition between the OFF and ON states, that alternates within a switching period, are determined by the external control signal CTRL, with a delay $t_{ON}$ and $t_{OFF}$ and an amplitude Vcc and $V_{EE}$ imposed by the calculation module 3. As a result, the applied gate driver voltage is modified in time and amplitude. As an example, the amplitude variation is between 0V and 5V, and the time is between 0ns and 500ns (see [Fig. 6]).

In some embodiments, the method further comprises the following preliminary operation:

- switching said at least one Metal-Oxide-Semiconductor element (11)

  * from an ON state to an OFF state, according to a CTRL logic signal with a zero or negative gate voltage $V_{EE}$ and with a delay time for the turning-off $t_{off}$;
  or
  * from an OFF state to an ON state, according to a CTRL logic signal with a positive gate voltage Vcc and with a delay time for the turning-on $t_{on}$.

In some embodiments, a part of the method forms an iterative loop such that, after the control signal CTRL generation of a preceding loop, the method is reiterated as a current loop such that the series of operations b to d are reiterated at least one time, starting from an acquisition of a second value $V_{SOH,X+1}$ a second time. In the examples, the first value $V_{soh,0}$ is not reacquired a second time and is reused for each loop. In the following, the indexes "X" and "X+1" are used to designate respectively an iteration and the successive one.

In the following, some various examples will be presented about the manner to deduce the gate voltage Vcc or $V_{EE}$ and the delay time $t_{ON}$ or $T_{OFF}$ in function of acquired first value $V_{soh,0}$ and second value $V_{soh,X}$ (operation c), and/or in function of successive values $V_{soh,X}$ and $V_{soh,X+1}$. An embodiment can comprise a combination of features issued from such examples.

**Example A**

The series of operations, including the acquisition of the gate oxide state of health $V_{soh}$, can be made only once on a switching period (succession of ON + OFF state). In various embodiments, it can be made twice on a switching period, a first one for the ON state, a second one for the OFF state.

Advantageous, the ON and OFF switching times can be adapted according to the permanent state of health of the gate oxide. In this last case, a ON state of health $V_{sohP}$ and a OFF state of health $V_{sohN}$ are defined respectively for the ON and OFF states. Advantageous, the ON and OFF switching times are adapted according to the permanent and transitory state of health of the gate oxide.

In some embodiments, the gate oxide state of health $V_{soh}$ is acquired at a fixed time delay after the turn-off of the semiconductor element 11. The ON state of health $V_{sohP}$ can be acquired just before or just after the turn-off, for example within $10\mu s$ before/after the turn-off.

In some embodiments, the OFF state of health $V_{sohN}$ is acquired just before the turn-on, for example within $10\mu s$ before the turn-on. Alternatively, the OFF state of health $V_{sohN}$ can be made continually (within $10\mu s$ between estimations) during the off-time. The last value acquired before the turn-on is kept. In addition, an external signal can control when the OFF state of health $V_{sohN}$ should be acquired.

The initial state of health $V_{soh,0}$ of the semiconductor element 11 can be obtained during the first hours of operation of the module 1, for example 2 hours. In various embodiments, it can be obtained during the commissioning phase for each semiconductor element. Or it can be pre-programed based on the measurements in a batch of representative power semiconductor elements, like a nominal value.

**Example B**

In some embodiments, it is possible to optimize the switching instants of the semiconductor element 11 in face of the gate oxide deterioration. For this aim, the delay time of the switching sequence can be adjusted in case the gate oxide state of health voltage $V_{soh}$ shifts during the module 1 operation (along the lifetime) to avoid shoot-through currents and excessive losses due to body diode conduction. Advantageous, the switching times are adaptative related to the gate oxide deterioration. This enables to reduce the design margins and increase the module efficiency.

To do that, it is possible to change in time, the rinsing edge and the falling edge of the signal that controls the semiconductor element 11. For example:

- If $V_{soh,X} > V_{soh,0}$, the delay $t_{ON}$ is decreased and the delay $t_{OFF}$ is increased;
- If $V_{soh,X} < V_{soh,0}$, the delay $t_{ON}$ is increased and the delay $t_{OFF}$ is decreased.

In the initial conditions, $t_{ON}$ and $t_{OFF}$ can be set to an initial value $t_{ON,0}$ and $t_{OFF,0}$, e.g. 300ns and 200ns respectively.

In case the state of health of the gate oxide corresponds to the threshold voltage $V_{th}$, the applied $t_{ON}$ and $t_{OFF}$ delays can be calculated as it follows in [Math. 5] and [Math. 6], or in [Math. 5] and [Math. 7].

[Math. 5]

$$t_{ON} = t_{ON,0} + \Delta t_{ON} \; ; \; t_{OFF} = t_{OFF,0} + \Delta t_{OFF}$$

[Math. 6]

$$\Delta t_{ON} = Rg \cdot Ciss \cdot ln\left(\frac{V_{soh,X} - V_{CC}}{V_{soh,X} - V_{CC}}\right) \; ; \; \Delta t_{OFF} = Rg \cdot Ciss \cdot ln\left(\frac{V_{soh,X} - V_{EE}}{V_{soh,X} - V_{EE}}\right)$$

[Math. 7]

$$\Delta t_{ON} = Rg \cdot Ciss \cdot ln\left(\frac{V_{sohP,X} - V_{CC}}{V_{sohP,X} - V_{CC}}\right) \; ; \; \Delta t_{OFF} = Rg \cdot Ciss \cdot ln\left(\frac{V_{sohN,X} - V_{EE}}{V_{sohN,X} - V_{EE}}\right)$$

Rg being the external and internal total gate resistances and Ciss being the input gate capacitance that can be approximated by the oxide capacitance. When it is combined with the example where the state of heath is made twice in a switching period, the $V_{sohP,X}$ is used for determining the turn-ON delay $t_{ON}$ and the $V_{sohN,X}$ is used to determine the turn-off delay $t_{OFF}$.

In the case the state of health corresponds to the flatband voltage $V_{fb}$, the equation [Math. 2] and [Math. 3] are used in the place of the $V_{soh}$ variable in the previous equation.

In the system, delays $t_{ON}$ and or $t_{OFF}$ cannot be negative values. Thus, the $t_{ON,0}$ and $t_{OFF,0}$ considers the maximum delay time variation of the semiconductor element considering a maximum deterioration of its gate oxide state of health during the lifetime. In this case, the initial delay $t_{OFF,0}$ is calculated as a function of the minimum gate oxide state of health and the initial delay $t_{ON,0}$ is calculated as the maximum value as $t_{OFF}$ plus a security margin "dead time" that integrates the turn-on and turn-off classical delays for a non-deteriorate device as [Math. 8].

[Math. 8]

$$t_{OFF,0} = Rg \cdot Ciss \cdot ln\left(\frac{min(V_{soh,X}) - V_{EE}}{V_{soh,0} - V_{EE}}\right) ; t_{ON,0} = Rg \cdot Ciss \cdot ln\left(\frac{max(V_{soh,X}) - V_{CC}}{V_{soh,0} - V_{CC}}\right) + Deadtime$$

## Example C

In some embodiments, it is possible to maintain constant the conduction loses of the semiconductor elements in face of a gate oxide deterioration. For this aim, the positive gate voltage Vcc is adjusted in time for the case the state of health of the gate oxide shifts during the semiconductor element operation, avoiding excessive heat on the semiconductor element. Advantageous, the initial positive gate voltage $V_{CC,0}$ can be designed lower than a nominal value to avoid fast gate oxide deterioration. In other words, the increasing of the positive gate voltage Vcc is made progressively/iteratively to avoid overvoltage and corresponding useless heating.

For example:

- If $V_{soh,X+1} > V_{soh,X}$, increase the positive gate voltage Vcc,x+i with respect to its previous value Vcc,x.

In order to not cause more damage to the gate oxide by the application of a more positive voltage, this condition/rule can be activated only when the semiconductor element is loaded by more than a predetermined portion (for example 60%) of the initial maximum load design. The "load" in this context can be, for example, the main collector/drain current or the junction temperature.

For example, the increasing value is equal to the evolution of the state of health absolute difference between the initial state of health and the current state of health:

$$V_{CC,X} = V_{CC,0} + V_{soh,X} - V_{soh,0}.$$

## Example D

In some embodiments, it is possible to reduce (not necessarily stop or repair) the deterioration of gate oxide by applying an opposite gate voltage bias under the power semiconductor module operation. Advantageous, the gate charge trapped can be reduced by applying a different gate voltage than the classical operation without disturbing normal operation. Thus, any charge accumulation that leads to a deterioration of the power semiconductor operation mode is slowed before any irreversible failure which could be catastrophic.

For example:

- If $V_{soh,X} > V_{soh,0}$ applying a lower voltage during the OFF state ($V_{EE,X} < V_{EE,0}$)
- If $V_{soh,X} < V_{soh,0}$ applying a higher voltage during the OFF state ($V_{EE,X} > V_{EE,0}$)
- If $V_{soh,X} = V_{soh,0}$ applying the same voltage during the OFF state ($V_{EE,X} = V_{EE,0}$)

By decreasing the negative gate bias on the semiconductor element ($V_{EE}$) more holes are captured in the gate oxide and the positive bias instability is compensated by a negative bias instability reducing the speed of the deterioration. In the opposite way, by increasing the negative gate bias on the semiconductor element, less holes are captured in the gate oxide and the negative bias instability is reduced.

In first examples: $V_{EE,X} = V_{EE,0} + V_{soh,0} - V_{soh,X}$.

$$V_{EE} = -5V; V_{soh,0} = 3V; V_{soh,X} = 4V, \text{ then } V_{EE,X} = -6V$$

$$V_{EE} = -5V; V_{soh,0} = 3V; V_{soh,X} = 2V, \text{ then } V_{EE,X} = -4V$$

In second examples: $V_{EE,X} = V_{EE,0} + k (V_{soh,0} - V_{soh,X})$, where k is a predetermined factor, for example 0,05.

### Example E

In some embodiments, it is possible to stop (not only reduce but not necessarily repair) further deterioration of gate oxide of the semiconductor element by changing the negative and/or positive gate voltage bias under the semiconductor module operation. Advantageous, the gate charge trapped can be slowed down by applying a different gate voltage than the classical operation. Thus, any charge accumulation that leads to a deterioration of the power semiconductor operation mode is stopped before any irreversible failure which could be catastrophic.

For example:

- If $dV_{soh,X}/dt > 0$, applying a lower voltage $V_{EE,X}$ during the OFF state and/or applying a lower voltage Vcc,x during the ON state
- If $dV_{soh,X}/dt < 0$, applying a higher voltage $V_{EE,X}$ during the OFF state and/or applying a higher voltage Vcc,x during the ON state.

By reducing the negative gate bias on the semiconductor element, more holes are captured in the gate oxide and the positive bias instability is compensated by a negative bias instability reducing the speed of the deterioration. In the opposite way, by increasing the negative gate bias on the semiconductor element, less holes are captured in the gate oxide and the negative bias instability is reduced.

The voltages $V_{EE,X}$, respectively Vcc,x, can be calculated in function of the derivative of the $V_{soh,X}$, a predetermined gain K and the previous values $V_{EE,0}$, respectively $V_{CC,0}$. For example: $V_{EE,X} = V_{EE,0} + K_{EE} dV_{soh,x}/dt$, and Vcc,x $= V_{CC,0} + Kcc \, dV_{soh,x}/dt$. And for example: $K_{EE} = Kcc = 1min/V$.

In various example, different gains K can be used according to the sign of the derivative:

- If dVsoh,x/dt > 0, $K_{CC} < K_{EE}$
- If dVsoh,x/dt < 0, $K_{CC} > K_{EE}$.

Such conditions/rules limit the further increase of the conduction losses when a positive temperature bias instability is present ($dV_{soh,X}/dt > 0$). And it limits the impact on the self-turn-on (by the increase of $V_{EE}$) when the negative gate bias is present ($dV_{soh,X}/dt < 0$).

### Example F

In some embodiments, it is possible to apply a recovery sequence to the power semiconductor module to remove the positive or negative Bias Temperature Instability. Advantageous, the gate charge trapped can be removed from the gate oxide by applying a different gate voltage than the classical operation and for only a limited time. Thus, any charge accumulation that leads to a deterioration of the power semiconductor operation mode is stopped before any irreversible failure which could be catastrophic. Furthermore, the restoration can be made in a short step of time avoiding the deterioration to propagate.

For example:

- If $V_{soh,X} > V_{soh,0}$, applying a more negative voltage ($V_{EE,X} < V_{EE,0}$) during the OFF state;
- If $V_{soh,X} < V_{soh,0}$, applying a higher (positive) voltage (Vcc,x > Vcc,o) during the OFF state;
- If $V_{soh,X} = V_{soh,0}$, applying the same voltages ($V_{EE,X} = V_{EE,0}$ ; Vcc,x = Vcc,o) during the OFF, respectively ON, state.

This mode can be applied during the idle state of the power semiconductor module, when $V_{EE}$ and Vcc are kept during several hours. To accelerate the recovery, the power semiconductor module can be heated.

**Example G**

In some embodiments, it is possible to apply an OFF-state or an ON-state gate voltage $V_{EE}$ and/or Vcc during the reverse conduction of the semiconductor element, depending on the shift of the state of health (for example the flatband voltage $V_{fb}$). Advantageous, this can be implemented on-line in applications such as inverters where the device is operating in both forward and reverse conduction mode.

**Example H**

In some embodiments, it is possible to change the timing according to the degradation and the new applied voltage Vcc and $V_{EE}$. In other words, the value of the timings depends on the applied voltages. Advantageous, all the output characteristic of the semiconductor element is maintained constant.

The delay time is calculated based on the initial and deteriorate gate oxide state of health and initial positive and negative gate voltage, Vcc, $V_{EE}$ and determined positive and negative gate voltage, $V_{CC,X}$, $V_{EE,X}$.

The timing is calculated according to [Math. 9] and [Math. 10], or [Math. 9] and [Math. 11].

[Math. 9]

$$t_{ON} = t_{ON,0} + \Delta t_{ON,1} \; ; \; t_{OFF} = t_{OFF,0} + \Delta t_{OFF,1}$$

[Math 10]

$$\Delta t_{ON} = Rg \cdot Ciss \cdot ln\left(\frac{V_{soh,X} - V_{CC,X}}{V_{EE,X} - V_{CC,X}} \cdot \frac{V_{EE,0} - V_{CC,0}}{V_{soh,0} - V_{CC,0}}\right);$$

$$\Delta t_{OFF} = Rg \cdot Ciss \cdot ln\left(\frac{V_{soh,X} - V_{EE,X}}{V_{CC,X} - V_{EE,X}} \cdot \frac{V_{CC,0} - V_{EE,0}}{V_{soh,0} - V_{EE,0}}\right)$$

[Math. 11]

$$\Delta t_{ON} = Rg \cdot Ciss \cdot ln\left(\frac{V_{sohP,X} - V_{CC,X}}{V_{EE,X} - V_{CC,X}} \cdot \frac{V_{EE,0} - V_{CC,0}}{V_{sohP,0} - V_{CC,0}}\right);$$

$$\Delta t_{OFF} = Rg \cdot Ciss \cdot ln\left(\frac{V_{sohN,X} - V_{EE,X}}{V_{CC,X} - V_{EE,X}} \cdot \frac{V_{CC,0} - V_{EE,0}}{V_{sohN,0} - V_{EE,0}}\right)$$

As particularly advantageous embodiments, the features of example H can be combined with features of Examples C and D. For example:

- for an Rg = 12$\Omega$; Ciss = 10e-9 and the following initial conditions, $V_{CC,0}$ = 15V; $V_{EE,0}$ = -5V; $V_{sohP} = V_{sohN}$ = 3V, $t_{ON,0}$ = 500ns; $t_{OFF,0}$ = 250ns; $t_{ON,0}$ = 298.6ns;
- For a deteriorate state of health $V_{sohP,X} = V_{sohN,X}$ = 4; The features of example C will impose Vcc,x = 16V; $V_{EE}$ = -6V;
- The timing $t_{OFF,X}$ = 302ns and $t_{ON,X}$ = 287.2ns.

**Summary of the examples**

The preceding examples are summarized in the following table.

[Table 1]

| Situation | $\uparrow V_{soh}$ | $\downarrow V_{soh}$ |
|---|---|---|
| Example A | Change $V_{CC}$, $V_{EE}$, $t_{ON}$, $t_{OFF}$ | Change Vcc, $V_{EE}$, $t_{ON}$, $t_{OFF}$ |
| Example B | $\downarrow t_{ON}$, $\uparrow t_{OFF}$ | $\uparrow t_{ON}$, $\downarrow t_{OFF}$ |
| Example C | $\uparrow V_{CC}$ (device is loaded by more than 60%) | - |
| Example D | $\downarrow V_{EE}$ | $\uparrow V_{EE}$ |
| Example E | $\downarrow V_{EE}$ Based on the dVsoh/dt | $\uparrow V_{EE}$ Based on the dVsoh/dt |
| Example F | $\downarrow V_{EE}$ | $\uparrow V_{CC}$ |
| Example G | Reverse conduction | Reverse conduction |
| Example H | Change $t_{ON}$, $t_{OFF}$ | Change $t_{ON}$, $t_{OFF}$ |

This disclosure is not limited to the methods, modules, circuitries and computer software described here, which are only examples. The invention encompasses every alternative that a person skilled in the art would envisage when reading this text.

**Reference Signs List**

- 1: module
- 2: detection module
- 3: calculation module
- 4: actuation module
- 5: gate driver voltage source
- 11: semiconductor element
- 12: control circuitry
- 21: indexes
- 22: indexes
- 31: semiconductor element
- 32: voltage source
- 33: gate resistance
- CTRL: control signal.

**Claims**

1. A treatment method of a power semi-conductor module (1) comprising at least one semiconductor element (11) including a Metal-Oxide-Semiconductor element and/or a Metal-Insulator-Semiconductor element, said method comprising:

   a. acquiring a first value $V_{soh,0}$ corresponding to an initial state of health of a gate oxide of the module (1);
   b. acquiring a second value $V_{soh,X}$ corresponding to a current state of health of a gate oxide of the module (1);
   c. deducing

   an ON-state gate voltage Vcc or an OFF-state gate voltage gate voltage $V_{EE}$, and
   a delay time of the turn-on $t_{ON}$ or a delay time of the turn-off $t_{OFF}$
   in function of said acquired first value $V_{soh,0}$ and said second value $V_{soh,X}$;

   d. generating at least one control signal (CTRL) configured to apply the deduced gate voltage Vcc or $V_{EE}$ to the module (1) during the deduced delay time $t_{ON}$ or $t_{OFF}$.

2. The method according to claim 1, further comprising the following preliminary operation:

   - switching said at least one semiconductor element (11)

     * from an ON-state to an OFF-state, according to a control logic signal with a zero or negative gate voltage $V_{EE}$ and with a delay time for the turning-off $t_{OFF}$;
     or
     * from an OFF-state to an ON-state, according to a control logic signal with a positive gate voltage Vcc and with a delay time for the turning-on $t_{ON}$.

3. The method according to one of the preceding claims, wherein the sign of the applied gate voltage Vcc or $V_{EE}$ depends on the ON/OFF state of said at least one semiconductor element (11).

4. The method according to one of the preceding claims, wherein criteria to deduce the delay time of the turn-on $t_{on}$ or the delay time of the turn-off $t_{OFF}$ in function of said acquired first value $V_{soh,0}$ and said acquired second value $V_{soh,X}$ includes the following:

   - if the acquired second value $V_{soh,X}$ is superior to the acquired first value $V_{soh,0}$, the delay time of the turn-off $t_{OFF}$ is increased with respect to a previous value of the delay time of the turn-off $t_{OFF}$;
   - if the acquired second value $V_{soh,X}$ is inferior to the acquired first value $V_{soh,0}$, the delay time of the turn-off $t_{OFF}$ is decreased with respect to a previous value of the delay time of the turn-off $t_{OFF}$.

5. The method according to one of the preceding claims, wherein criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

   - if the acquired second value $V_{soh,X}$ is superior to the acquired first value $V_{soh,0}$, the ON-state gate voltage Vcc is increased with respect to a previous value of the ON-state gate voltage Vcc, and the increasing is proportional or equal to the difference between the acquired first value $V_{soh,0}$ and the acquired second value $V_{soh,X}$.

6. The method according to one of the preceding claims, wherein criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

   - if the acquired second value $V_{soh,X}$ is superior to the acquired first value $V_{soh,0}$, the OFF-state gate voltage $V_{EE}$ is decreased with respect to a previous value of the OFF-state gate voltage $V_{EE}$;
   - if the acquired second value $V_{soh,X}$ is inferior to the acquired first value $V_{soh,0}$, the OFF-state gate voltage $V_{EE}$ is increased with respect to a previous value of the OFF-state gate voltage $V_{EE}$;
   - if the acquired second value $V_{soh,X}$ is equal to the acquired first value $V_{soh,0}$, the OFF-state gate voltage $V_{EE}$ is maintained equal to a previous value of the OFF-state gate voltage $V_{EE}$.

7. The method according to one of the preceding claims, wherein criteria to deduce the ON-state gate voltage Vcc or an OFF-state gate voltage gate voltage $V_{EE}$ in function of said acquired first value $V_{soh,0}$ and said acquired second value $V_{soh,X}$ includes the following:

   - if the acquired second value $V_{soh,X}$ is superior to the acquired first value $V_{soh,0}$, the OFF-state gate voltage $V_{EE}$ is decreased with respect to a previous value of the OFF-state gate voltage $V_{EE}$;
   - if the acquired second value $V_{soh,X}$ is inferior to the acquired first value $V_{soh,0}$, the ON-state gate voltage Vcc is increased with respect to a previous value of the ON-state gate voltage Vcc;
   - if the acquired second value $V_{soh,X}$ is equal to the acquired first value $V_{soh,0}$, the ON-state gate voltage Vcc and the OFF-state gate voltage $V_{EE}$ are each reinitialized to their respective value by default.

8. The method according to one of the preceding claims, further comprising the following operation:

   - when a reverse conduction of the semiconductor element (11) is detected, generating at least one control signal (CTRL) configured to apply the deduced gate voltage Vcc or $V_{EE}$ to the module (1).

9.  The method according to one of the preceding claims, wherein a part of the method forms an iterative loop such that the series of operations b to d are reiterated at least one time, starting from an acquisition of a second value $V_{SOH,X+1}$ a second time.

10. The method according to claim 9, wherein at least two second values $V_{soh,X}$ and $V_{soh,X+1}$ are acquired during the lifetime of the module (1), and wherein criteria to deduce the ON-state gate voltage Vcc or an OFF-state gate voltage gate voltage $V_{EE}$ in function of said acquired first value $V_{soh,0}$ and said acquired second values $V_{soh,X}$ and $V_{soh,X+1}$ includes the following:

    - if the temporal derivative of the said acquired second values $dV_{soh,X}/dt$ is positive, the ON-state gate voltage Vcc is decreased with respect to a previous value of the ON-state gate voltage Vcc and/or the OFF-state gate voltage $V_{EE}$ is decreased with respect to a previous value of the OFF-state gate voltage $V_{EE}$;
    - if the temporal derivative of the said acquired second values $dV_{soh,X}/dt$ is negative, the ON-state gate voltage Vcc is increased with respect to a previous value of the ON-state gate voltage Vcc and/or the OFF-state gate voltage $V_{EE}$ is increased with respect to a previous value of the OFF-state gate voltage $V_{EE}$.

11. The method according to one of the preceding claims, wherein criteria to deduce the delay time of the turn-on $t_{ON}$ or the delay time of the turn-off $t_{OFF}$ is further dependent from the ON-state gate voltage Vcc and/or the OFF-state gate voltage gate voltage $V_{EE}$.

12. A power semi-conductor module (1) comprising a single Metal-Oxide-Semiconductor element or a set of Metal-Oxide-Semiconductor elements or a single Metal-Insulator-Semiconductor element or a set of Metal-Insulated-Semiconductor elements, said module being arranged to implement the method according to one of claims 1 to 11.

13. Computer software comprising instructions to implement the method according to one of claims 1 to 11 when the software is executed by a processor.

14. Computer-readable non-transient recording medium on which a software is registered to implement the method according to one of claims 1 to 11 when the software is executed by a processor.

FIG. 1

FIG. 2

FIG. 3

**FIG. 4**

FIG. 5

FIG. 6

## EUROPEAN SEARCH REPORT

Application Number

EP 22 30 5351

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 884 663 A1 (IMEC VZW [BE]) 17 June 2015 (2015-06-17) * abstract * * paragraphs [0001] – [0023] * * paragraphs [0028] – [0090] * * paragraphs [0098], [0099] * * figures 1-22 * | 1-14 | INV. H03K17/14 H03K17/687 H03K17/16 H01L29/16 |
| A | US 2012/176183 A1 (TANAKA KOUTAROU [JP] ET AL) 12 July 2012 (2012-07-12) * the whole document * | 1-13 | |
| A | XIE MINGHANG ET AL: "Online Gate-Oxide Degradation Monitoring of Planar SiC MOSFETs Based on Gate Charge Time", IEEE TRANSACTIONS ON POWER ELECTRONICS, INSTITUTE OF ELECTRICAL AND ELECTRONICS ENGINEERS, USA, vol. 37, no. 6, 11 January 2022 (2022-01-11), pages 7333-7343, XP011900482, ISSN: 0885-8993, DOI: 10.1109/TPEL.2022.3142139 [retrieved on 2022-02-15] * the whole document * | 1-14 | |

-/--

| | TECHNICAL FIELDS SEARCHED (IPC) |
|---|---|
| | H03K H01L |

The present search report has been drawn up for all claims

| Place of search | Date of completion of the search | Examiner |
|---|---|---|
| The Hague | 30 August 2022 | João Carlos Silva |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 22 30 5351

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | ZHONG XIAOHAN ET AL: "Bias Temperature Instability of Silicon Carbide Power MOSFET Under AC Gate Stresses", IEEE TRANSACTIONS ON POWER ELECTRONICS, INSTITUTE OF ELECTRICAL AND ELECTRONICS ENGINEERS, USA, vol. 37, no. 2, 18 August 2021 (2021-08-18), pages 1998-2008, XP011883154, ISSN: 0885-8993, DOI: 10.1109/TPEL.2021.3105272 [retrieved on 2021-10-14] * the whole document * | 1-14 | |
| A | HAYASHI SHIN-ICHIRO ET AL: "Gate Drive Circuit with In situ Condition Monitoring System for Detecting Gate Oxide Degradation of SiC MOSFETs", 2022 IEEE APPLIED POWER ELECTRONICS CONFERENCE AND EXPOSITION (APEC), IEEE, 20 March 2022 (2022-03-20), pages 1838-1845, XP034125125, DOI: 10.1109/APEC43599.2022.9773501 [retrieved on 2022-05-19] * the whole document * | 1-14 | TECHNICAL FIELDS SEARCHED (IPC) |
| A | NI ZE ET AL: "Overview of Real-Time Lifetime Prediction and Extension for SiC Power Converters", IEEE TRANSACTIONS ON POWER ELECTRONICS, INSTITUTE OF ELECTRICAL AND ELECTRONICS ENGINEERS, USA, vol. 35, no. 8, 27 December 2019 (2019-12-27), pages 7765-7794, XP011785204, ISSN: 0885-8993, DOI: 10.1109/TPEL.2019.2962503 [retrieved on 2020-04-22] * the whole document * | 1-14 | |

The present search report has been drawn up for all claims

| Place of search | Date of completion of the search | Examiner |
|---|---|---|
| The Hague | 30 August 2022 | João Carlos Silva |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
### ON EUROPEAN PATENT APPLICATION NO.

EP 22 30 5351

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2022

| Patent document cited in search report | | Publication date | Patent family member(s) | | Publication date |
|---|---|---|---|---|---|
| EP 2884663 | A1 | 17-06-2015 | EP | 2884663 A1 | 17-06-2015 |
| | | | KR | 20150070020 A | 24-06-2015 |
| | | | US | 2015171857 A1 | 18-06-2015 |
| US 2012176183 | A1 | 12-07-2012 | CN | 102473726 A | 23-05-2012 |
| | | | JP | 5096638 B2 | 12-12-2012 |
| | | | JP | 2013012769 A | 17-01-2013 |
| | | | JP WO2011148617 A1 | | 25-07-2013 |
| | | | US | 2012176183 A1 | 12-07-2012 |
| | | | WO | 2011148617 A1 | 01-12-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **X. ZHONG.** Bias Temperature Instability of Silicon Carbide Power MOSFET Under AC Gate Stresses. *IEEE Transactions on Power Electronics,* February 2022, vol. 37 (2), 1998-2008